# EUROPEAN PATENT APPLICATION

(11) **EP 2 168 763 A1**
(43) Date of publication of application: **31.03.2010**
(21) Application number: 08790691.3
(22) Date of filing: 27.06.2008
(51) Int. Cl.: B32B 9/00, C23C 16/42

(54) **RESIN SUBSTRATE**

(30) Priority: 27.06.2007 JP 2007169658
(71) Applicant: Ulvac, Inc., Chigasaki-shi Kanagawa 253-8543 (JP); Ube Industries, Ltd., Ube-shi Yamaguchi 755-8633 (JP)
(72) Inventor: FUJINAGA, Tetsushi, Sammu-shi Chiba 289-1226 (JP); TAKAGI, Makiko, Sammu-shi Chiba 289-1226 (JP); HASHIMOTO, Masanori, Sammu-shi Chiba 289-1226 (JP); ASARI, Shin, Sammu-shi Chiba 289-1226 (JP); OYAMA, Ryuji, Tokyo 105-8449 (JP)
(74) Representative: Luderschmidt, Schüler & Partner
(86) International application number: PCT/JP2008/061726
(87) International publication number: WO 2009/001924

(57) **Abstract**

A resin substrate of the present invention has a resin layer and a surface layer formed on a surface of the resin layer, wherein the surface layer is a layer comprising silicon nitride as a main component and deposited by the chemical vapor deposition method, and at the interface between the resin layer and the surface layer, at the interface between the resin layer and the surface layer, an interfacial region over which a percentage changes from 80% to 20% has a thickness of not more than 25 nm, wherein the difference between the maximum nitrogen concentration in the surface layer and the steady-state nitrogen concentration in the resin layer is taken as 100%. The surface layer has an average surface roughness (Ra) of not more than 1 nm. The resin substrate has properties of water vapor barrier and surface flatness.

## Description

### Technical Field

The present invention relates to a resin substrate which is used in the field of electronic equipments and is excellent in water vapor barrier properties.

### Background Art

A liquid crystal display element (LCD: Liquid Crystal Display) has been used for large size displays including flat panel TVs as typical examples, and a medium or small size display for car navigation systems or cellular phones. As displays capable of realizing a clear picture, organic electroluminescence (OLED: Organic Light Emitting Diode) displays have also been intensively investigated.

Glass substrates, which has been used in these LCD and OLED displays, are easily broken when they are dropped. Furthermore, thickness of glass substrates have been reduced in order to satisfy the demand for reduction in weight and reduction in thickness of LCDs that are mounted on portable devices. This has caused further problems such as an increased risk of breakage of the glass substrate in the production thereof, which leads to the deterioration of the production yield, the lowered handling properties and the lowered production efficiency.

Then, the production of LCD and OLED displays using a resin substrate has been attempted. The driving methods of such flexible displays are roughly divided into two kinds: a passive matrix driving method for easily realizing mass production and an active matrix driving method suitable for achieving a high-definition screen. Displays for each method have been actively investigated.

Meanwhile, as a substrate for a photovoltaic power generation element, a silicon wafer has been used. A photovoltaic power generation module is produced by spreading the silicon wafers all over one surface of base material(s) provided with necessary electrical wirings. A semiconductor layer formed as a surface layer on the silicon wafer has a function of generating electric power. Most of expensive silicon wafers are, however, used only as a supporting body. Accordingly, modules become expensive, the weight is increased, and there is also a problem from the viewpoint of the utilization of resources. The achievement of a photovoltaic power generation element having an equivalent efficiency has been investigated by forming a silicon thin film on a glass substrate or a resin substrate. The resin substrate is expected because it is advantageous for impact resistance and lightweight, whereas a power generation efficiency is inferior to that of a silicon wafer product in the present stage. Furthermore, the use of a resin substrate increases the freedom of design such as device shapes or the like, which makes it possible to satisfy variety of needs.

In view of the purpose of reduction in weight, impact resistance and the like, there has been demanded a resin substrate which can replace a glass substrate in the field of electronic products. The use of a film substrate as a resin substrate allows a roll-to-roll production method due to its flexibility and bending properties, whereby the production speed is also expected to be dramatically improved as compared to a single-wafer type which has been adopted for a glass substrate.

In the field of LCDs, one of properties to be required for a resin substrate is water vapor barrier properties. It is said, for example, to be not more than 0.1 g/m²/day for LCD, and to be further 1/100,000 or less thereof for OLED. With a single resin substrate, it is not possible to achieve the required water vapor barrier properties. So, a thin barrier film has been deposited on a surface of the resin substrate by a vacuum vapor deposition method, a sputtering method, or other film forming methods from the past. Japanese Laid-open Patent Publication No. 2004-292877 (Patent Document 1) and Japanese Laid-open Patent Publication No. 2005-342975 (Patent Document 2) disclose that a silicon nitride film formed by the catalytic chemical vapor deposition method (Cat-CVD method) exhibits excellent properties as a barrier thin film.

In the field of LCDs, another property to be required for a resin substrate is surface flatness of the substrate. For example, in Japanese Laid-open Patent Publication No. 2006-351523 (Patent Document 3), four or more layers of extremely thin layers having a layer thickness of about 5 to 20 nm with individual functions are laminated for constituting an OLED display. Therefore, surface properties of a transparent electrically-conductive film, as an under layer, may become the cause of wire breakage or short circuit during the production process, and the cause of non-uniform luminance or defects, and thus influence on the device reliability. According to the claims of Japanese Laid-open Patent Publication No. 2004-111201 (Patent Document 4), even in a surface of a glass substrate, an average roughness (Ra) of a transparent electrically-conductive film deposited thereon is preferably not more than 1 nm.
Patent Document 1: Japanese Laid-open Patent Publication No. 2004-292877
Patent Document 2: Japanese Laid-open Patent Publication No. 2005-342975
Patent Document 3: Japanese Laid-open Patent Publication No. 2006-351523
Patent Document 4: Japanese Laid-open Patent Publication No. 2004-111201

### Disclosure of the Invention

### Problems to be Solved by the Invention

However, in the past, it was not be possible to obtain a resin substrate which has water vapor barrier properties necessary for securing long-term reliability of electronic products and excellent surface flatness (i.e. surface smoothness), together. Accordingly, an object of the present invention is to provide a resin substrate which satisfies water vapor barrier properties and surface flatness simultaneously.

### Means for Solving the Problems

The present invention relates to the following items.

1. A resin substrate comprising a resin layer and a surface layer formed on a surface of the resin layer, wherein
the surface layer is a layer comprising silicon nitride as a main component and deposited by the chemical vapor deposition, and
at the interface between the resin layer and the surface layer, an interfacial region over which a percentage changes from 80% to 20% has a thickness of not more than 25 nm, wherein the difference between the maximum nitrogen concentration in the surface layer and the steady-state nitrogen concentration in the resin layer is taken as 100%.

2. The resin substrate according to the above item 1, wherein the resin substrate satisfies at least one of (i) that the water vapor permeation rate is not more than 0.1 g/m²/day and (ii) that the surface layer has an average surface roughness (Ra) of not more than 1 nm, and preferably satisfies both of (i) and (ii).

3. The resin substrate according to the above item 1 or 2, wherein the resin layer comprises a polyimide layer.

4. A method for producing a resin substrate, comprising steps of:
providing a resin layer and
forming a surface layer comprising silicon nitride as a main component on the resin layer by the catalytic chemical vapor deposition.

5. The method for producing a resin substrate according to the above item 4, comprising a step of drying the resin layer before the step of forming the surface layer.

6. The method for producing a resin substrate according to the above item 5, wherein, in the step of forming the surface layer, the resin layer is dried under reduced pressure and the surface layer is formed while maintaining the reduced pressure.

7. The method for producing a resin substrate according to any one of the above items 4 to 6, wherein the resin layer comprises a polyimide layer.

### Effect of the Invention

The resin substrate of the present invention is excellent in water vapor barrier properties and surface flatness. Accordingly, it is suitably used, for example, as a substrate of electronic components and electronic products such as LCDs, OLEDs, solar cells or the like, and as a result, a product with reduced weight or a flexible product is obtained.

### Brief Description of the Drawings

Fig. 1 is a view illustrating an example of a resin substrate.
Fig. 2 is a view illustrating an example of a resin substrate.
Fig. 3 is a view illustrating an example of a resin substrate.
Fig. 4 is a graph illustrating a method of determining an atomic concentration profile in the vicinity of an interface of a resin substrate, and of determining a thickness (d) of the interfacial region.
Fig. 5 is a graph illustrating a method of determining the thickness (d) of the interfacial region.
Fig. 6 is a photographic image of a surface (surface of silicon nitride layer) of the resin substrate obtained in Example 1 with a scanning electron microscope.
Fig. 7 is a photographic image of a surface (surface of silicon nitride layer) of the resin substrate obtained in Comparative Example 1 with a scanning electron microscope.

### Explanation of the References

- 1: Resin layer
- 1a: Resin base layer
- 2: Surface layer
- 3: Transparent electrically-conductive film
- 4: Film (gas barrier film, electrode layer, or the like)
- 5: Surface-smoothing layer
- 6: Inorganic film
- 7: Organic film

### Best Mode for Carrying Out the Invention

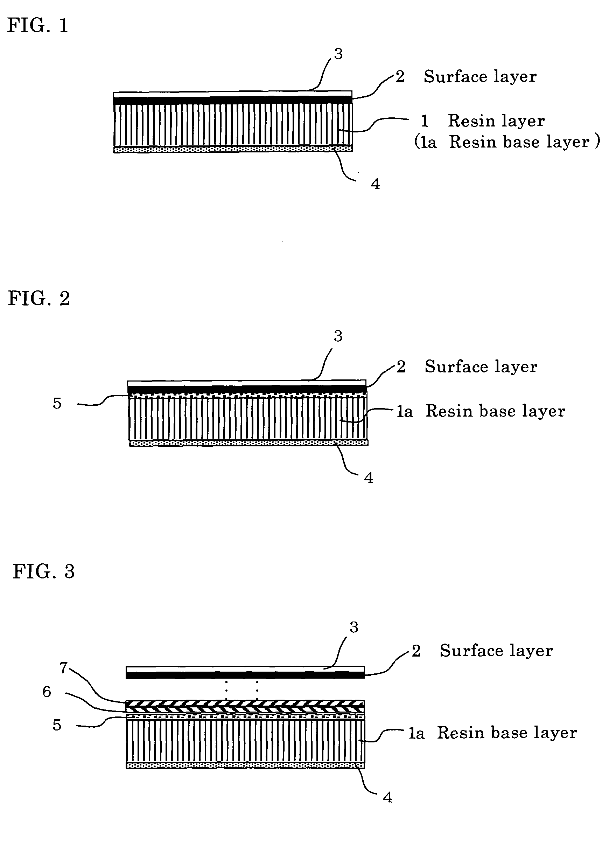

The resin substrate of the present invention has a structure, as shown in Fig. 1, with a surface layer 2 formed on a surface of a resin layer 1. In representative uses, on a surface of the surface layer of the resin substrate is formed, for example, a transparent electrically-conductive film 3. Furthermore, as necessary, a film 4 such as a gas barrier film, an electrode layer or the like may be formed on a back surface of the resin layer 1.

In one of preferred embodiments is a resin layer composed only of a resin base layer 1a in a film form or the like having a resin as a main component. However, as necessary, the resin layer may have other layers or films. For example, as shown in Fig. 2, the resin layer may have a surface-smoothing layer 5 together with the resin base layer 1a. The surface-smoothing layer 5 may be formed using a known organic or inorganic material. In one embodiment of the present invention, the resin substrate may further have a supplementary multilayered surface layer, in addition to the surface-smoothing layer or without the surface-smoothing layer. As shown in Fig. 3, the supplementary multilayered surface layer is composed, for example, of a surface-smoothing layer 5 for enhancing the smoothness, an inorganic film 6 mainly having a function of water vapor barrier properties, an organic film 7 having a function of compensating defects of the inorganic film or the smoothness, or the like. Known constructions may be employed for the surface-smoothing layer and the supplementary multilayered surface layer. The supplementary surface layer may be arranged between the surface layer 2 and the resin base layer 1a, may be arranged on a side of the resin base layer 1a opposite to the surface layer 2, or the surface layer 2 may be inserted between the layers of the supplementary multilayered surface layer.

While, in Figs. 1 to 3, the surface layer 2 is formed on one surface of the resin layer 1, it may also be formed on both surfaces thereof. In this case, the film 4 may not be formed.

As the resin base layer, there can be used a known material having a so-called resin layer or a resin substrate. The material is not particularly limited, but preferably used are heat resistant resins such as polyimide resins, polyamideimide resins, polyamide resins, liquid crystal polymers, polyethylene naphthalate and the like which have been used for many products as a flexible wiring board or a heat resistant material and in which the high reliability has been confirmed. Furthermore, there can also be exemplified a heat resistant transparent resin such as polyether sulfone, polycarbonate, polycycloolefin and the like having a glass transition temperature of not less than 100°C, a thermosetting resin having a transparent epoxy resin as a main component, or a hybrid resin with an inorganic component added to a thermoplastic resin or a thermosetting resin.

As the resin base layer, its thickness is, for example, from about 1 to 200 µm and preferably from about 5 to 200 µm. Preferably used are obtainable polyimide films. The resin base layer can be produced by a known method, and examples thereof include those produced by a casting method, a solution casting method such as a solution coating method or the like, those produced by a melt extrusion method, those produced by a vapor deposition method and the like. The layer may be in the form of a film, a sheet, a plate or the like.

As the resin base layer, preferably used are available polyimide films, polyamide films, polyamideimide films and the like.

The surface layer is a layer comprising silicon nitride as a main component and deposited by the chemical vapor deposition method. Although the surface layer may preferably contain Al oxide, Si oxide or the like as a constituent material which has been used as an additive, in addition to silicon nitride, it is preferable that the nitrogen concentration is greater than the oxygen concentration (nitrogen concentration > oxygen concentration) in the vicinity of the interface of the resin substrate. The proportion of silicon nitride in the surface layer is generally not less than 30 atom%, preferably not less than 50 atom%, more preferably not less than 70 atom%, and further preferably not less than 90 atom%. Herein, "atom%" indicating the proportion of silicon nitride represents the total proportion (percent) of a nitrogen atom and a silicon atom to all existing atoms. Furthermore, the range of the vicinity of the interface to satisfy the condition of "nitrogen concentration > oxygen concentration" refers to a range from the position of 80% of "the interfacial region over which the nitrogen concentration changes from 80% to 20%" to be described below to the position located into the inside of the surface layer, at least by the distance same as the thickness of the interfacial region. More preferably, it is a region between the position of 80% and the position located into the inside by 25 nm therefrom.

In a thin film having silicon nitride as a main component, it has been known that even though the thickness of the surface layer is extremely thin, water vapor barrier properties are exhibited. However, the thickness is not less than 5 nm, preferably not less than 10 nm, further preferably not less than 20 nm and particularly preferably not less than 50 nm in consideration of coverage of the resin substrate surface. On the other hand, when it is extremely thick, crack easily occurs. So, in consideration of the productivity, it is not more than 1,000 nm, preferably not more than 500 nm and further preferably not more than 200 nm. The silicon nitride constituting the surface layer is favorably used in the field of displays because of its transparency, and it is also preferable from the viewpoint of chemical resistance or the like. The refractive index at the He-Ne laser wavelength is generally in the range of 1.60 to 2.05, preferably in the range of 1.70 to 2.05 and further preferably in the range of 1.80 to 2.05.

In general, as a method of forming a thin film comprising silicon nitride as a main component, there have been known a physical vapor deposition method such as vacuum deposition, sputtering, ion plating or the like; and a chemical deposition method (chemical vapor deposition) such as plasma CVD, catalytic chemical vapor deposition (Cat-CVD method) or the like. However, for example, the physical vapor deposition may achieve the water vapor permeation rate of 1 g/m²/day, but barrier properties are not sufficient in view of the present object in some cases. Furthermore, the vacuum deposition is generally excellent in the film deposition rate, but there are problems such that the strength of the thin film itself is weak, problems in terms of the process such as peeling and the like occur during the process for forming a flexible device, and it is hard to maintain long-term reliability. According to the sputtering method and the ion plating method, the strength of the thin film itself is stronger than that according to the vacuum vapor deposition method, but the large residual stress easily remains in the thin film so that deformation such as warping or curling easily occurs to the resin substrate after film deposition.

Then, film deposition for forming the surface layer on the surface of the resin layer in the present invention is carried out preferably by the chemical vapor deposition method from the viewpoints of barrier properties, adhesiveness and residual stress, and particularly preferably by the Cat-CVD method which has a high film deposition rate and is advantageous for mass productivity without the need of a large high-frequency power supply.

In the resin substrate of the present invention, at the interface between the resin layer and the surface layer, when the difference between the maximum nitrogen concentration in the surface layer and the steady-state nitrogen concentration in the resin layer is taken as 100%, the interfacial region over which the nitrogen concentration changes from 80% to 20% has a thickness of not more than 25 nm. The thickness of the interfacial region is determined in the following manner.

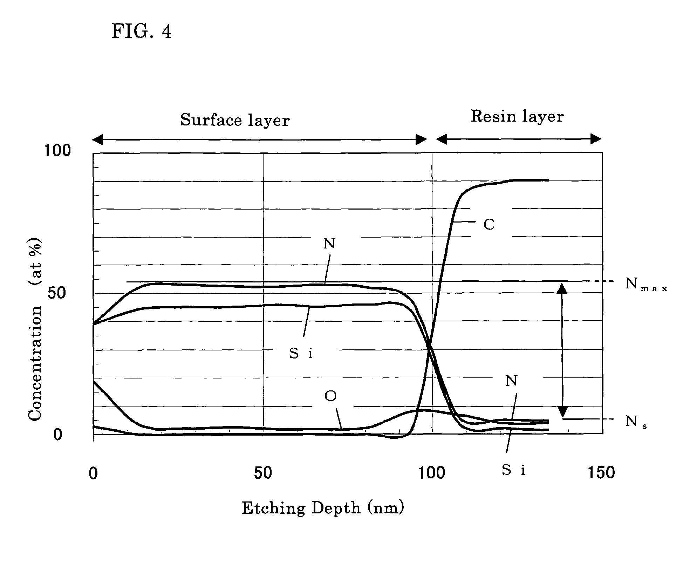

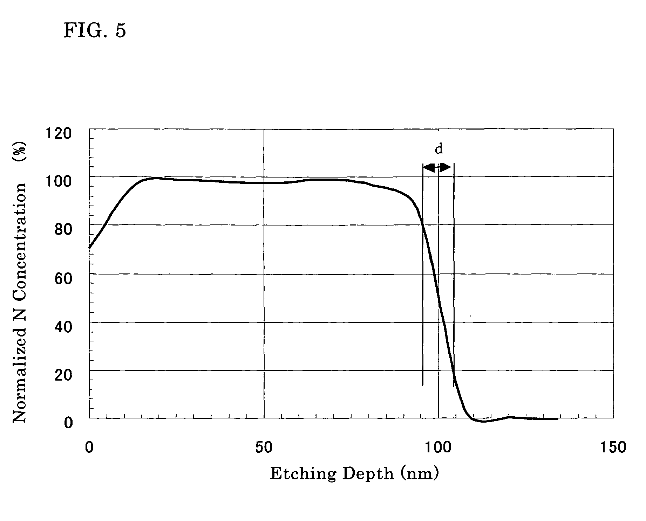

Fig. 4 illustrates an example of the atomic concentration profile ranging from the surface layer to the resin layer for the resin substrate with silicon nitride deposited on the polyimide film. The atomic concentration profile may be measured by the X-ray photoelectron spectroscopy while etching from a side of the surface layer. In order to minimize a measurement error, in the present invention, the thickness of the interfacial region is determined by normalizing in the following manner. By paying attention to the nitrogen atomic concentration in Fig. 4, the maximum nitrogen concentration (Nₘₐₓ) in the surface layer is obtained; on the other hand, the steady-state nitrogen atomic concentration (Nₛ) in the resin layer is obtained. The steady-state concentration (Nₛ) corresponds to the nitrogen concentration in the polyimide film bulk. Taking Nₘₐₓ-Nₛ as a base (= 100%) for normalization, the nitrogen concentration profile is rewritten as represented by a graph illustrated in Fig. 5. At the interface, the distance over which the normalized nitrogen concentration is reduced from 80% to 20% is determined as the thickness (d) of the interfacial region.

The present invention is characterized in that the thus-obtained thickness (d) of the interfacial region is not more than 25 nm, preferably not more than 20 nm and further preferably not more than 15 nm, and the lower limit is 0 nm, preferably 1 nm, more preferably 2 nm and further preferably 5 nm. The resin substrate satisfying such conditions has high surface flatness. The average surface roughness (Ra) of the surface layer thereof is usually not more than 1 nm, preferably not more than 0.5 nm and further preferably not more than 0.50 nm, and the lower limit is preferably 0 nm because a low water vapor permeation rate is exhibited.

Herein, in order to have the average surface roughness (Ra) of the surface layer of not more than 1 nm, the roughness (Ra) of the surface (note that a surface-smoothing layer or other layer(s) may be present on the surface) of the resin layer, on which the surface layer is formed, is also not more than 1 nm, preferably not more than 0.5 nm and further preferably not more than 0.50 nm, and the lower limit is preferably 0 nm.

In order to have the interfacial region having a thickness (d) of not more than 25 nm, it is preferable to remove moisture at least from the surface of the resin layer as much as possible before the formation of the surface layer. Specifically, the resin layer may be dried, for example, the entire resin layer is preferably dried by heating and/or under reduced pressure. In case of heating, it is preferable to heat at 100°C or higher, and the upper limit of the heating temperature is preferably the temperature in which the resin substrate is not subject to plastic deformation or decomposition or lower, and preferably not more than 300°C for the polyimide. It is more preferable to reduce the pressure at the same time. The surface layer comprising silicon nitride as a main component is deposited by Cat-CVD on the surface of the resin layer in which moisture is suitably removed from the surface, whereby the resin substrate with the interfacial region having a thickness (d) of not more than 25 nm is produced.

The thus-produced resin substrate with the interfacial region having a thickness (d) of not more than 25 nm exhibits water vapor barrier properties of not more than 0.1 g/m²/day in a preferred embodiment. The resin substrate of the present invention may optionally have an inorganic film and/or an organic film and/or a multilayered film in combination of an inorganic-organic composite film as described above. However, according to one embodiment of the present invention, even though the resin base layer and the surface layer are combined, it is possible to achieve water vapor barrier properties of not more than 0.1 g/m²/day.

Besides, the glass transition temperature of respective materials used in the present invention (particularly concerning the resin material) is preferably not less than 100°C.

### Examples

### Film Deposition of Gas Barrier Film

As a resin layer, a polyimide film (UPILEX film, S type, film thickness: 50 µm, a product of UBE Industries, Ltd.) was used. A silicon nitride thin film was formed by the Cat-CVD method. When only a silane gas and an ammonia gas were used for a raw material gas, the amount of the silane gas to be fed was 7.5 sccm, and the amount of the ammonia gas to be fed was 200 sccm. When a hydrogen gas was added for improvement of the quality of the film, a silane gas flow rate was 7.5 sccm, an ammonia gas flow rate was 50 sccm, and a hydrogen gas flow rate was 200 sccm. As a catalyst for decomposing raw material gas, a tungsten wire having a wire diameter of 0.5 mmϕ was palced so as to make uniform the film thickness distribution, and heated at 1700°C at the time of film deposition.

After the ammonia gas and the hydrogen gas were introduced in a chamber and the chamber became stable, film deposition was started by introducing the silane gas. Herein, the temperature of the substrate holder for arranging the polyimide film was taken as the surface temperature of the film at the time of the start of film deposition. The gas pressure, the surface temperature of the film at the time of the start of film deposition, and other film deposition conditions such as growth time and the like were set such that the refractive index of the silicon nitride thin film at the He-Ne laser wavelength was 1.80 to 2.05 and a film thickness was 100 nm.

### Method of Measurement of Refractive Index

Under the same conditions as those of film deposition on the polyimide film, a sample obtained by forming a silicon nitride film on a silicon wafer was measured with an ellipsometer using a He-Ne laser as a light source.

### Evaluation of Water Vapor Barrier Properties

To evaluate water vapor barrier properties, a barrier resin substrate in which a silicon nitride film was formed only on one surface of the polyimide film by the Cat-CVD method was used. Water vapor barrier properties were measured using PERMATRAN-W3/31 manufactured by Modern Control Inc. for the analysis under measuring conditions of 40°C and 90% RH at a measuring area of 50 mm². The lower detection limit was 0.02 g/m²/day.

### Composition Analysis and Determination of Thickness of Interfacial Region

A Quantum2000 scanning X-ray photoelectron spectrometer manufactured by PHI was used for the measurement. For composition analysis, with respect to main component elements, Si2p, N1s, O1s and C1s peaks were detected at an analyzing area of 100 µm × 100 µm, and relative sensitivity factors supplied by PHI were used for the calculation.

The thickness of the interfacial region was calculated from the nitrogen concentration profile measured by repeatedly conducting ion etching of an argon gas and the above composition analysis from the surface of the silicon nitride film to the inside of the polyimide film at appropriate intervals. For the ion etching region by the argon gas, an area, an acceleration voltage, an ion beam profile and the like were set so as to achieve sufficient flatness at the analyzing area. The etching depth for one ion etching was set so as to have a resolution enabling to confirm the interfacial region.

### Evaluation of Average Surface Roughness (Ra)

A D3100 type scanning probe microscope manufactured by Digital Instruments was used for the measurement. The scan size was 1 x 1 µm, while data pixels were 512 × 512. In general, for a resin substrate, particularly a film, inorganic fillers as a slipping material were added to facilitate the production in many cases. The size of the inorganic filler was selected depending on the purpose, from nano-order to micro-order. However, since it was extremely large with respect to the desired average surface roughness of the present invention, as the measuring region of the average surface roughness, a region was selected such that the slipping material did not have influence. Incidentally, in the actual production, since a surface-smoothing film or the like was formed for the purpose of improvement of the smoothness, irregularities of the slipping material were covered.

### Scanning Electron Microscope Observation

An S-4800 field emitting scanning electron microscope available from Hitachi High-Technologies Corporation was used for observation with an acceleration voltage of 5kV and a sample tilt angle of 30°.

### Example 1

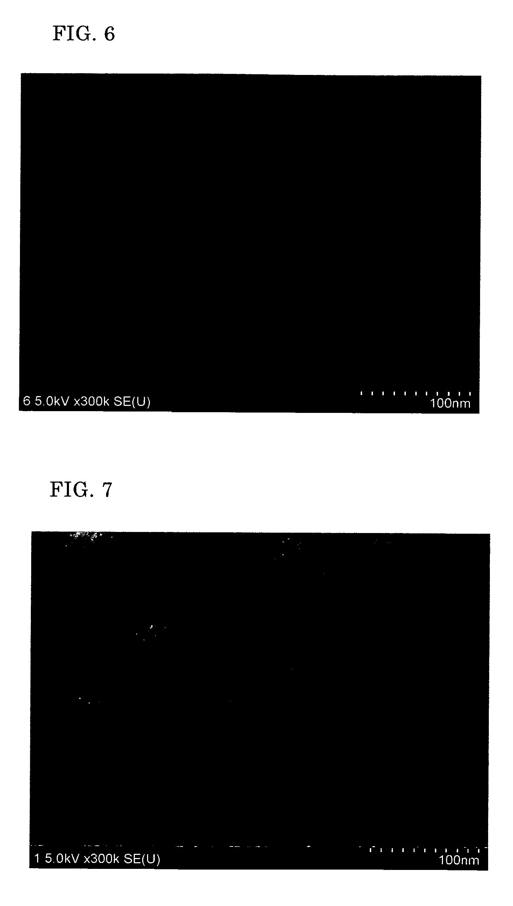

A polyimide film was kept at a high degree of vacuum of 1 × 10⁻⁴ Pa or smaller at room temperature for 12 hours to remove water in the film, and then subsequently the substrate temperature at the start of film deposition was set to 30°C, and the gas pressure at the time of film deposition was set to 30 Pa, whereby a silicon nitride barrier film was formed with a film thickness of 100 nm. The thickness (d) of the interfacial region, the average surface roughness (Ra) of the barrier film and the water vapor permeation rate are shown in Table 1. A photographic image obtained by observing a surface of the barrier film with a scanning electron microscope is shown in Fig. 6.

### Example 2

A polyimide film was set on a substrate holder heated to 100°C and dried at a high degree of vacuum of 5 × 10⁻⁵ Pa or smaller, and subsequently the substrate temperature at the start of film deposition was set to 100°C, and the gas pressure at the time of film deposition was set to 30 Pa, whereby a barrier film comprising silicon nitride as a main component was formed with a film thickness of 100 nm. The thickness (d) of the interfacial region, the average surface roughness (Ra) of the barrier film and the water vapor permeation rate are shown in Table 1.

### Comparative Example 1

Without employing a special treatment for removing water from the polyimide film, the substrate temperature at the start of film deposition was set to 30°C, and the gas pressure at the time of film deposition was set to 30 Pa, whereby a barrier film comprising silicon nitride as a main component was formed with a film thickness of 100 nm. The thickness (d) of the interfacial region, the average surface roughness (Ra) of the barrier film and the water vapor permeation rate are shown in Table 1. A photographic image obtained by observing a surface of the barrier film with a scanning electron microscope is shown in Fig. 7.

### Comparative Example 2

Without employing a special treatment for removing water from the polyimide film, the substrate temperature at the start of film deposition was set to 30°C, and the gas pressure at the time of film deposition was set to 4 Pa, whereby a barrier film comprising silicon nitride as a main component was formed with a film thickness of 100 nm. The thickness (d) of the interfacial region, the average surface roughness (Ra) of the barrier film and the water vapor permeation rate are shown in Table 1.

### Comparative Example 3

The average surface roughness and the water vapor permeation rate of the polyimide (UPILEX S) film used in respective Examples and Comparative Examples are shown in Table 1.

**[Table 1]**

| | Thickness in the interfacial region: d (nm) | Average surface roughness (Ra) (nm) | Water Vapor Permeation Rate (g/m²/day) |
|---|---|---|---|
| Example 1 | 11 | 0.48 | 0.06 |
| Example 2 | 19 | 0.54 | 0.19 |
| Comparative Example 1 | 32 | 2.86 | 0.07 |
| Comparative Example 2 | 27 | 1.78 | 0.08 |
| Comparative Example 3 | -- | 0.42 | 0.94 |

## Claims

1. A resin substrate comprising a resin layer and a surface layer formed on a surface of the resin layer, wherein
the surface layer is a layer comprising silicon nitride as a main component and deposited by the chemical vapor deposition, and
at the interface between the resin layer and the surface layer, an interfacial region over which a percentage changes from 80% to 20% has a thickness of not more than 25 nm, wherein the difference between the maximum nitrogen concentration in the surface layer and the steady-state nitrogen concentration in the resin layer is taken as 100%.

2. The resin substrate according to claim 1, wherein the water vapor permeation rate is not more than 0.1 g/m²/day, and the surface layer has an average surface roughness (Ra) of not more than 1 nm.

3. The resin substrate according to claim 1 or 2, wherein the resin layer comprises a polyimide layer.

4. A method for producing a resin substrate, comprising steps of:
providing a resin layer and
forming a surface layer comprising silicon nitride as a main component on the resin layer by the catalytic chemical vapor deposition.

5. The method for producing a resin substrate according to claim 4, comprising a step of drying the resin layer before the step of forming the surface layer.

6. The method for producing a resin substrate according to claim 5, wherein, in the step of forming the surface layer, the resin layer is dried under reduced pressure and the surface layer is formed while maintaining the reduced pressure.

7. The method for producing a resin substrate according to any one of claims 4 to 6, wherein the resin layer comprises a polyimide layer.
